# EUROPEAN PATENT APPLICATION

(11) **EP 4 386 037 A1**
(43) Date of publication of application: **19.06.2024**
(21) Application number: 22855730.2
(22) Date of filing: 09.06.2022
(51) Int. Cl.: C08G 77/60, C08G 59/02, C08G 77/14, C08G 77/52, C08G 77/54, G03F 7/004, G03F 7/075, G03F 7/20

(54) **SILPHENYLENE-SKELETON-CONTAINING POLYMER, PHOTOSENSITIVE RESIN COMPOSITION, PATTERN FORMATION METHOD, AND METHOD FOR MANUFACTURING OPTICAL SEMICONDUCTOR DEVICE**

(30) Priority: 12.08.2021 JP 2021131720; 01.03.2022 JP 2022030950
(71) Applicant: SHIN-ETSU CHEMICAL CO., LTD., Tokyo 1000005 (JP)
(72) Inventor: OMORI Hiroto, Annaka-shi, Gunma 379-0224 (JP); MARUYAMA Hitoshi, Annaka-shi, Gunma 379-0224 (JP)
(74) Representative: Mewburn Ellis LLP
(86) International application number: PCT/JP2022/023304
(87) International publication number: WO 2023/017666

(57) **Abstract**

Provided is a polymer that includes a silphenylene skeleton, an isocyanuric acid skeleton, and a hydroxy-group-substituted alkyl ether skeleton in the main chain, and that includes an epoxy group in a side chain.

## Description

### TECHNICAL FIELD

The present invention relates to a silphenylene skeleton-containing polymer, a photosensitive resin composition, a patterning process and a method for fabricating an optical semiconductor device.

### BACKGROUND ART

Transparent epoxy resins have hitherto been used as sealing and protective materials or as adhesives in various types of optical devices such as light-emitting diodes (LEDs) and CMOS image sensors. Nowadays, microfabrication is often required in the production of optical devices and so use is often made of resist materials that employ epoxy resins.

Given the trend today toward higher power in optical devices such as LEDs, there is a desire for materials which are suitable for microfabrication and which moreover, in order to suppress outgassing, discoloration and the like, have a higher transparency and light resistance than in the past. Materials suitable for microfabrication and having a particularly high transparency and light resistance include, for example, photosensitive materials that use an epoxy-modified silicone resin on which isocyanuric acid and norbornene skeletons have been introduced (Patent Document 1).

Recently, in addition to transparency and light resistance, there is a need for further improvements in the properties of such photosensitive materials, low-temperature curability being especially desired. However, the aforementioned epoxy-modified silicone resin is not a material that is curable at low temperatures of about 130°C. Accordingly, there exists a desire for a photosensitive material that uses a resin which has not only epoxy groups but also other highly reactive functional groups. Introducing other highly reactive functional groups onto an epoxy resin enables low-temperature curability to be achieved and can be expected to contribute also to an increase in processability. The result is a high value-added material which is suitable for microfabrication and can be cured at low temperature.

### PRIOR ART DOCUMENTS

### PATENT DOCUMENTS

Patent Document 1: JP-A 2020-90649

### SUMMARY OF INVENTION

### TECHNICAL PROBLEM

The present invention was arrived at in light of the above circumstances. An object of this invention is to provide a polymer which can be finely patterned using a broad range of wavelengths, which is curable at low temperature, and which can give a film having high transparency and high light resistance. Further objects of the invention are a photosensitive resin composition containing the polymer, a patterning process that uses the photosensitive resin composition, and a method for fabricating a semiconductor device.

### SOLUTION TO PROBLEM

As a result of intensive investigations, the inventors have discovered that a polymer which includes a silphenylene skeleton, an isocyanuric acid skeleton and a hydroxyl group-substituted alkyl ether skeleton on the main chain and which includes epoxy groups on side chains is curable at low temperature and can give a film having high transparency and high light resistance. The inventors have also found that a photosensitive resin composition containing the inventive polymer and a photoacid generator can be finely patterned using a broad range of wavelengths, is curable at low temperature, and gives a film having high transparency and high light resistance. These discoveries ultimately led to the present invention.

Accordingly, the invention provides the following silphenylene skeleton-containing polymer, photosensitive resin composition, patterning process and method for fabricating an optical semiconductor device.
1. A polymer having a silphenylene skeleton, an isocyanuric acid skeleton and a hydroxyl group-substituted alkyl ether skeleton on a main chain and an epoxy group on a side chain.
2. The polymer of 1 above, wherein the hydroxyl group-substituted alkyl ether skeleton has from 9 to 20 carbon atoms.
3. The polymer of 1 or 2 above, wherein the polymer includes recurring units of formula (A1) below, recurring units of formula (A2) below and recurring units of formula (A3) below 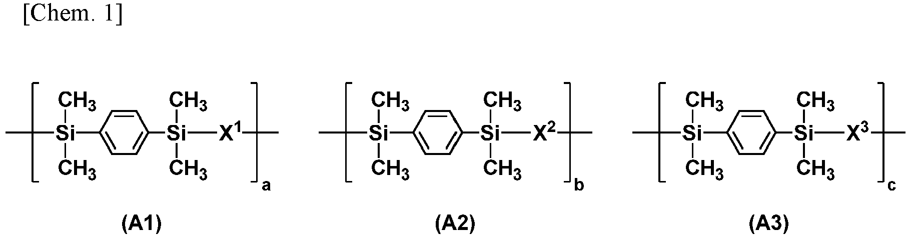 (wherein a, b and c are positive numbers that satisfy the conditions 0 < a < 1, 0 ≤ b < 1, 0 < c < 1 and a+b+c = 1; X¹ is a divalent group of formula (X1) below; X² is a divalent group of formula (X2) below; and X³ is a divalent group of formula (X3) below) 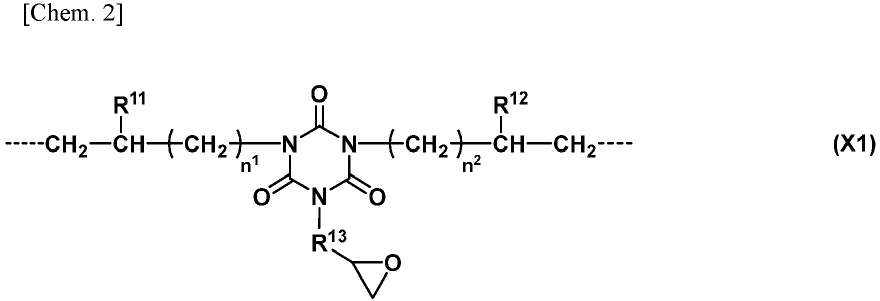 (wherein R¹¹ and R¹² are each independently a hydrogen atom or a methyl group; R¹³ is a hydrocarbylene group of 1 to 8 carbon atoms which may have an ester bond or ether bond interposed between carbon-carbon bonds thereon; n¹ and n² are each independently an integer from 0 to 7; and the dashed lines are bonds) 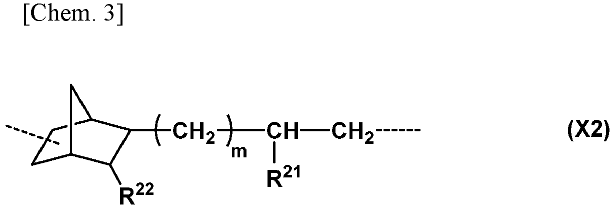 (wherein R²¹ and R²² are each independently a hydrogen atom or a saturated hydrocarbyl group of 1 to 20 carbon atoms which may include a heteroatom; m is an integer from 0 to 10; and the dashed lines are bonds) 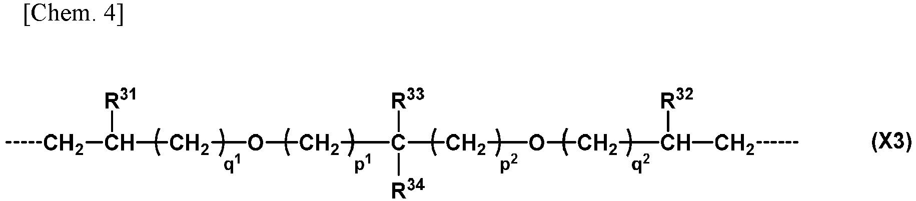 (wherein R³¹ and R³² are each independently a hydrogen atom or a methyl group; R³³ is a hydrogen atom or a saturated hydrocarbyl group of 1 to 20 carbon atoms which may include a heteroatom, with the proviso that R³³, when a saturated hydrocarbyl group, may include a primary or secondary alcoholic hydroxyl group as a substituent; R³⁴ is a hydroxyl group or a saturated hydrocarbyl group of 1 to 20 carbon atoms which may include a heteroatom, with the proviso that R³⁴, when a saturated hydrocarbyl group, may include a primary or secondary alcoholic hydroxyl group as a substituent; with the further provisos that when R³³ is a hydrogen atom and R³⁴ is a saturated hydrocarbyl group, R³⁴ includes at least one primary or secondary alcoholic hydroxyl group as a substituent; and when R³³ and R³⁴ are both saturated hydrocarbyl groups, one or both include at least one primary or secondary alcoholic hydroxyl group as a substituent; p¹ and p² are each independently an integer from 1 to 7; q¹ and q² are each independently an integer from 1 to 7; and the dashed lines are bonds).
4. The polymer of 3 above, wherein a, b and c are positive numbers which satisfy the conditions 0 < a < 1, 0 < b < 1, 0 < c < 1 and a+b+c = 1.
5. The polymer of 3 or 4 above, wherein R³⁴ is a linear alkyl group having a terminal hydroxyl group.
6. The polymer of any of 3 to 5 above, wherein R³¹ and R³² are hydrogen atoms.
7. The polymer of any of 3 to 6 above, wherein p¹ and p² are 1.
8. The polymer of any of 3 to 7 above, wherein q¹ and q² are 1.
9. The polymer of any of 1 to 8 above, wherein a 10 µm thick film made of the polymer has a transmittance to 400 nm wavelength light of 95% or more.
10. A photosensitive resin composition which includes the polymer of any of 1 to 9 above and (B) a photoacid generator.
11. The photosensitive resin composition of 10 above, further including (C) a cation-polymerizable crosslinking agent.
12. A patterning process which includes the steps of:
   (i) forming a photosensitive resin film on a substrate using the photosensitive resin composition of 10 or 11 above,
   (ii) exposing the photosensitive resin film to light, and
   (iii) developing the exposed photosensitive resin film with a developer.
13. A method for fabricating an optical semiconductor device having a photosensitive resin film, which method includes the patterning process of 12 above.

### ADVANTAGEOUS EFFECTS OF INVENTION

The polymer of the invention is curable at low temperatures, particularly low temperatures up to 130°C, and gives a film having high transparency and high light resistance. The inventive polymer can be easily synthesized. By using a photosensitive resin composition containing the inventive polymer, a fine pattern can be formed using light having a broad range of wavelengths. In addition, a film obtained from the photosensitive resin composition of the invention has excellent transparency and light resistance, can be low-temperature-cured at or below 130°C, and can be advantageously used in protective and sealing applications for optical semiconductor devices.

### DESCRIPTION OF EMBODIMENTS

### [Silphenylene Skeleton-Containing Polymer]

The polymer of the invention is a polymer which includes a silphenylene skeleton, an isocyanuric acid skeleton and a hydroxyl group-substituted alkyl ether skeleton on the main chain and an epoxy group on a side chain. The number of carbon atoms on the hydroxyl group-substituted alkyl ether skeleton is preferably from 9 to 20. The polymer may additionally include a norbornene skeleton on the main chain.

The polymer is preferably one which includes recurring units of formula (A1) below, recurring units of formula (A2) below and recurring units of formula (A3) below.

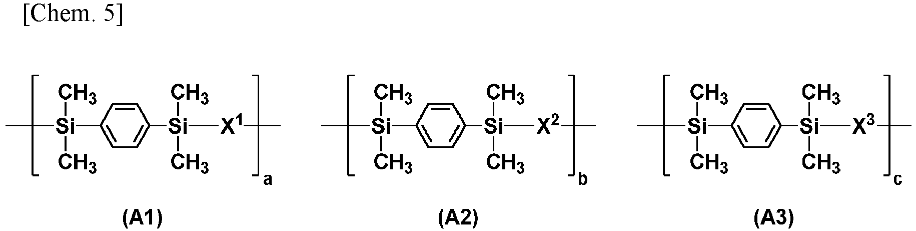

In formulas (A1) to (A3), a, b and c are positive numbers that satisfy the conditions 0 < a < 1, 0 ≤ b < 1, 0 < c < 1 and a+b+c = 1.

In formula (A1), X¹ is a divalent group of formula (X1) below 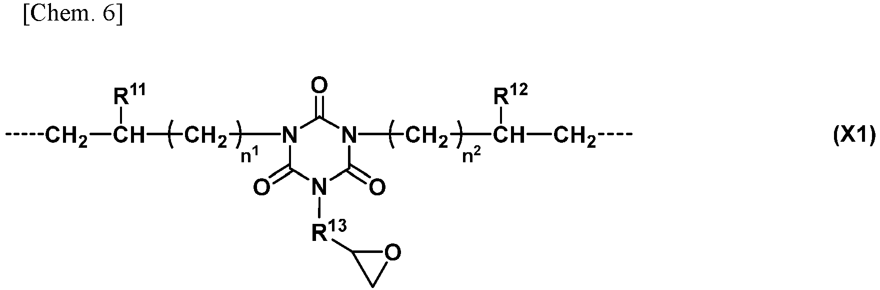 (wherein the dashed lines are bonds). The divalent group represented by formula (X1) is a group having an isocyanuric acid skeleton.

In formula (X1), R¹¹ and R¹² are each independently a hydrogen atom or a methyl group.

In formula (X1), R¹³ is a hydrocarbylene group of 1 to 8 carbons atoms which may have an ester bond or ether bond interposed between carbon-carbon bonds thereon. The hydrocarbylene group represented by R¹³ may be linear, branched or cyclic. Specific examples include alkanediyl groups such as methylene, ethane-1,1-diyl, ethane-1,2-diyl, propane-1,2-diyl, propane-1,3-diyl, butane-1,2-diyl, butane-1,3-diyl and butane-1,4-diyl groups. Of these, R¹³ is preferably a methylene group or an ethylene group; a methylene group is more preferred. An ester bond or ether bond may be interposed between carbon-carbon bonds on the hydrocarbylene group.

In formula (X1), n¹ and n² are each independently an integer from 0 to 7.

In formula (A2), X² is a divalent group of formula (X2) below 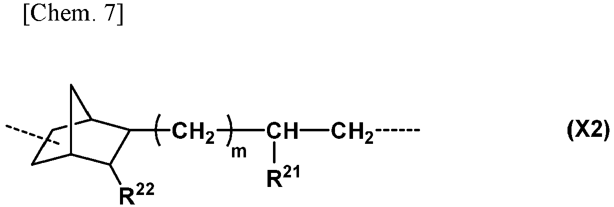 (wherein the dashed lines are bonds). The divalent group of formula (X2) is a group having a norbornene skeleton.

In formula (X2), R²¹ and R²² are each independently a hydrogen atom or a saturated hydrocarbyl group of 1 to 20 carbon atoms which may include a heteroatom. The saturated hydrocarbyl group may be linear, branched or cyclic. Specific examples include alkyl groups of 1 to 20 carbon atoms such as methyl, ethyl, n-propyl, isopropyl, n-butyl, isobutyl, sec-butyl, tert-butyl, n-pentyl, n-hexyl, n-heptyl, n-octyl, n-nonyl and n-decyl groups; and cyclic saturated hydrocarbyl groups of 3 to 20 carbon atoms such as cyclopropyl, cyclobutyl, cyclopentyl, cyclohexyl, norbornyl and adamantyl groups. A heteroatom may be included on the saturated hydrocarbyl group. Specifically, some or all hydrogen atoms on the saturated hydrocarbyl group may be substituted with halogen atoms such as fluorine, chlorine, bromine and iodine atoms, and carbonyl bonds, ether bonds, thioether bonds or the like may be interposed between carbon-carbon atoms thereon.

In formula (X2), m is an integer from 0 to 10, with 0 being preferred.

In formula (A3), X³ is a divalent group represented by formula (X3) below 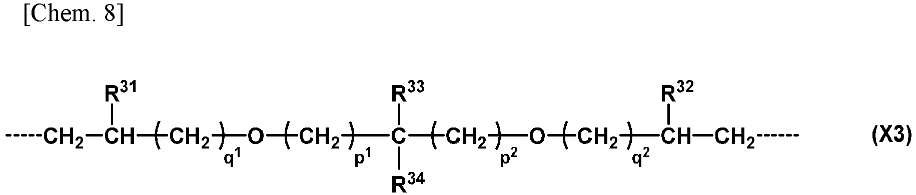 (wherein the dashed lines are bonds). The divalent group of formula (X3) is a group having a hydroxyl group-substituted alkyl ether skeleton.

In formula (X3), R³¹ and R³² are each independently a hydrogen atom or a methyl group, with a hydrogen atom being preferred.

In formula (3), R³³ is a hydrogen atom or a saturated hydrocarbyl group of 1 to 20 carbon atoms which may contain a heteroatom. When R³³ is a saturated hydrocarbyl group, it may include a primary or secondary alcoholic hydroxyl group as a substituent. R³⁴ is a hydroxyl group or a saturated hydrocarbyl group of 1 to 20 carbon atoms which may contain a heteroatom. When R³⁴ is a saturated hydrocarbyl group, it may include a primary or secondary alcoholic hydroxyl group as a substituent. The saturated hydrocarbyl groups represented by R³³ and R³⁴ may be linear, branched or cyclic. Specific examples include the same groups mentioned as exemplary saturated hydrocarbyl groups represented by R²¹ and R²² in the description of formula (X2). Also, the saturated hydrocarbyl group may include a heteroatom. Specifically, some or all hydrogen atoms on the saturated hydrocarbyl groups may be substituted with halogen atoms such as fluorine, chlorine, bromine and iodine atoms, and carbonyl bonds, ether bonds, thioether bonds or the like may be interposed between carbon-carbon atoms thereon.

When R³³ is a hydrogen atom and R³⁴ is a saturated hydrocarbyl group, R³⁴ includes at least one primary or secondary alcoholic hydroxyl group as a substituent. When R³³ and R³⁴ are both saturated hydrocarbyl groups, one or both include at least one primary or secondary alcoholic hydroxyl group as a substituent. When R³³ and R³⁴ include alcoholic hydroxyl groups, R³³ and R³⁴ are preferably linear alkyl groups containing a terminal primary alcoholic hydroxyl group.

In formula (X3), p¹ and p² are each independently an integer from 1 to 7, with 1 being preferred; q¹ and q² are each independently an integer from 1 to 7, with 1 being preferred. The number of carbon atoms included on the divalent group represented by formula (X3) is preferably from 9 to 20.

The polymer of the invention has a weight-average molecular weight (Mw) of preferably from 3,000 to 500,000, and more preferably from 5,000 to 200,000. At a Mw in this range, the polymer can be obtained as a solid, in addition to which film formability is ensured. In this invention, the Mw is a polystyrene-equivalent measured value obtained by gel permeation chromatography (GPC) using tetrahydrofuran (THF) as the eluting solvent.

The polymer of the invention may be a polymer in which the recurring units of formula (A1), the recurring units of formula (A2) and the recurring units of formula (A3) are randomly bonded, a polymer in which they are alternately bonded, or a polymer which contains blocks of these respective units.

In the polymer of the invention, a, b and c in formula (1) are positive numbers which satisfy the conditions 0 < a < 1, 0 ≤ b < 1, 0 < c < 1 and a+b+c = 1; preferably satisfy the conditions 0 < a < 1, 0 < b < 1 and 0 < c < 1; more preferably satisfy the conditions 0.1 < a < 0.8, 0.1 < b < 0.8 and 0.1 < c < 0.8; and even more preferably satisfy the conditions 0.15 < a < 0.65, 0.15 < b < 0.65 and 0.15 < c < 0.65.

### [Method for Preparing Silphenylene Skeleton-Containing Polymer]

The polymer can be prepared by addition polymerizing a compound of formula (1) below, a compound of formula (2) below, a compound of formula (4) below and, optionally, a compound of formula (3) below in the presence of a metal catalyst. 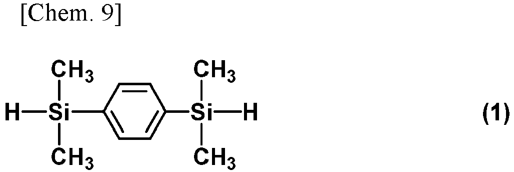 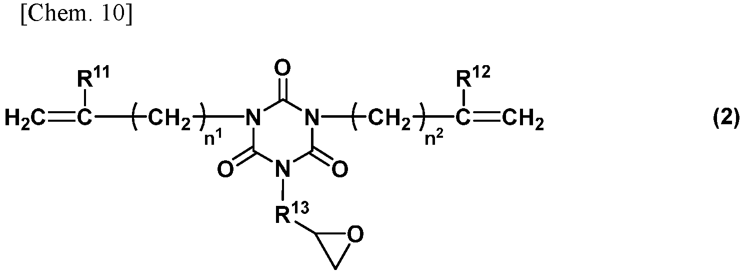 (wherein R¹¹ to R¹³ and n¹ and n² are the same as described above) 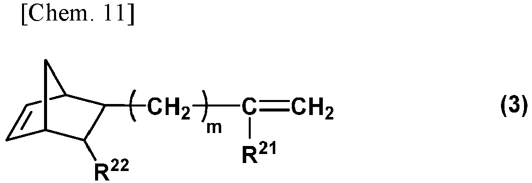 (wherein R²¹, R²² and m are the same as described above) 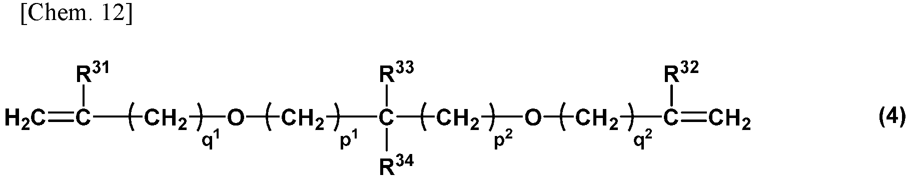 (wherein R³¹ to R³⁴, p¹, p², q¹ and q² are the same as described above)

Examples of substances that may be used as the metal catalyst include uncombined platinum group metals such as platinum (including platinum black), rhodium and palladium; platinum chloride, chloroplatinic acid and chloroplatinic acid salts such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂ and Na₂HPtCl₄·xH₂O (wherein x is preferably an integer from 0 to 6, with 0 or 6 being especially preferred); alcohol-modified chloroplatinic acids (such as those mentioned in U.S. Pat. No. 3,220,972); complexes of chloroplatinic acid and olefins (such as those mentioned in U.S. Pat Nos. 3,159,601, 3,159,662 and 3,775,452); platinum group metals such as platinum black or palladium on a support such as alumina, silica or carbon; rhodium-olefin complexes; chlorotris(triphenylphosphine)rhodium (Wilkinson's catalyst); and complexes of platinum chloride, chloroplatinic acid or a chloroplatinic acid salt with a vinyl group-containing siloxane (especially a vinyl group-containing cyclic siloxane).

The catalyst is used in a catalytic amount that is typically, in terms of the platinum group metal, from 0.001 to 0.1 wt% of the overall amount of polymerization reactants. A solvent may be optionally used in the polymerization reaction. The solvent is preferably, for example, a hydrocarbon solvent such as toluene or xylene. As for the polymerization conditions, from the standpoint of enabling polymerization to go to completion in a short time without a loss of catalytic activity, the polymerization temperature is preferably between 40°C and 150°C, and more preferably between 60°C and 120°C. The polymerization time varies also with the type and amount of polymerization product, although to keep moisture from entering the polymerization system, polymerization is preferably completed in from 0.5 to 100 hours, and especially from 0.5 to 30 hours. Following completion of the polymerization reaction, in cases where a solvent has been used, the polymer can be obtained by distilling off the solvent.

Although the reaction method is not particularly limited, it is desirable to first mix together and heat a compound of formula (2), a compound of formula (4) and optionally a compound of formula (3), subsequently add a metal catalyst to the mixed solution, and then add dropwise the compound of formula (1) over a period of from 0.1 to 5 hours.

It is desirable to blend the starting compounds such that the sum of the hydrosilyl groups on the compound of formula (1) with respect to the sum of the alkenyl groups on the compound of formula (2), the compound of formula (3) and the compound of formula (4), expressed as a molar ratio, is preferably from 0.67 to 1.67, and more preferably from 0.83 to 1.25. The weight-average molecular weight of the inventive polymer may be controlled by using a monoallyl compound such as o-allylphenol or a monohydrosilane or monohydrosiloxane such as triethylhydrosilane as a molecular weight regulator.

The polymer of the invention is preferably one such that a 10 µm thick film obtained from the polymer has a transmittance to 400 nm wavelength light of 95% or more.

### [Photosensitive Resin Composition]

The photosensitive resin composition of the invention includes (A) the above silphenylene skeleton-containing polymer and (B) a photoacid generator.

### [(B) Photoacid Generator]

The photoacid generator serving as component (B) is not particularly limited, so long as it is a compound which decomposes under light irradiation and generates an acid, although one which generates an acid when irradiated with light having a wavelength of from 190 to 500 nm is preferred. The photoacid generator (B) can be used as a curing catalyst. Examples of this photoacid generator include onium salts, diazomethane derivatives, glyoxime derivatives, β-ketosulfone derivatives, disulfone derivatives, nitrobenzyl sulfonate derivatives, sulfonate ester derivatives, imidoyl sulfonate derivatives, oxime sulfonate derivatives, iminosulfonate derivatives and triazine derivatives.

The onium salts are exemplified by sulfonium salts of formula (B1) below and iodonium salts of formula (B2) below.

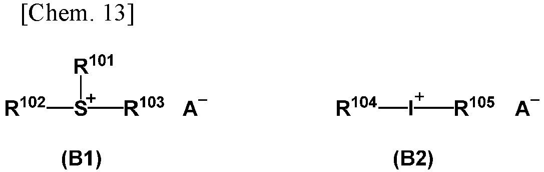

In formulas (B 1) and (B2), R¹⁰¹ to R¹⁰⁵ are each independently a saturated hydrocarbyl group of 1 to 12 carbon atoms that may have a substituent, an aryl group of 6 to 12 carbon atoms that may have a substituent, or an aralkyl group of 7 to 12 carbon atoms that may have a substituent. A⁻ is a non-nucleophilic counterion.

The saturated hydrocarbyl group may be linear, branched or cyclic. Specific examples include methyl, ethyl, n-propyl, isopropyl, cyclopropyl, n-butyl, isobutyl, sec-butyl, tert-butyl, cyclobutyl, n-pentyl, cyclopentyl, cyclohexyl, norbornyl and adamantly groups. Examples of the aryl groups include phenyl, naphthyl and biphenylyl groups. Examples of the aralkyl groups include benzyl and phenethyl groups.

Examples of the substituents include the oxo group, saturated hydrocarbyl groups of 1 to 12 carbon atoms, saturated hydrocarbyloxy groups of 1 to 12 carbon atoms, aryl groups of 6 to 24 carbon atoms, aralkyl groups of 7 to 25 carbon atoms, aryloxy groups of 6 to 24 carbon atoms and arylthiol groups of 6 to 24 carbon atoms.

R¹⁰¹ to R¹⁰⁵ are preferably saturated hydrocarbyl groups that may have a substituent, such as methyl, ethyl, propyl, butyl, cyclohexyl, norbornyl, adamantyl and 2-oxocyclohexyl groups; aryl groups that may have a substituent, such as phenyl, naphthyl, biphenylyl, 2-, 3- or 4-methoxyphenyl, 2-, 3- or 4-ethoxyphenyl, 3- or 4-tert-butoxyphenyl, 2-, 3- or 4-methylphenyl, 2-, 3- or 4-ethylphenyl, 4-tert-butylphenyl, 4-butylphenyl, dimethylphenyl, terphenylyl, biphenylyloxyphenyl and biphenylylthiophenyl groups; and aralkyl groups that may have a substituent, such as benzyl and phenethyl groups. Of these, aryl groups that may have a substituent and aralkyl groups that may have a substituent are more preferred.

Examples of the non-nucleophilic counterion include halide ions such as chloride and bromide ions; fluoroalkane sulfonate ions such as triflate, 1,1,1-trifluoroethanesulfonate and nonafluorobutanesulfonate ions; aryl sulfonate ions such as tosylate, benzenesulfonate, 4-fluorobenzenesulfonate and 1,2,3,4,5-pentafluorobenzenesulfonate ions; alkane sulfonate ions such as mesylate and butanesulfonate ions; fluoroalkane sulfonimide ions such as the trifluoromethanesulfonimide ion; fluoroalkanesulfonylmethide ions such as the tris(trifluoromethanesulfonyl)methide ion; and borate ions such as the tetrakisphenyl borate and tetrakis(pentafluorophenyl) borate ions.

The diazomethane derivatives are exemplified by compounds of formula (B3) below.

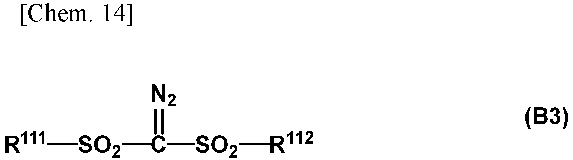

In formula (B3), R¹¹¹ and R¹¹² are each independently a saturated hydrocarbyl group or halogenated saturated hydrocarbyl group of 1 to 12 carbon atoms, an aryl group of 6 to 12 carbon atoms that may have a substituent, or an aralkyl group of 7 to 12 carbon atoms.

The saturated hydrocarbyl group is exemplified by the same groups mentioned above as examples of the saturated hydrocarbyl groups represented by R¹⁰¹ to R¹⁰⁵. Examples of the halogenated saturated hydrocarbyl group include trifluoromethyl, 1,1,1-trifluoroethyl, 1,1,1-trichloroethyl and nonafluorobutyl groups.

Examples of the aryl group which may have a substituent include the phenyl group; alkoxyphenyl groups such as 2-, 3- or 4-methoxyphenyl, 2-, 3- or 4-ethoxyphenyl and 3- or 4-tert-butoxyphenyl groups; alkylphenyl groups such as 2-, 3- or 4-methylphenyl, 2-, 3- or 4-ethylphenyl, 4-tert-butylphenyl, 4-butylphenyl and dimethylphenyl groups; and halogenated aryl groups such as fluorophenyl, chlorophenyl and 1,2,3,4,5-pentafluorophenyl groups. Examples of the aralkyl groups include benzyl and phenethyl groups.

The glyoxime derivatives are exemplified by compounds of formula (B4) below.

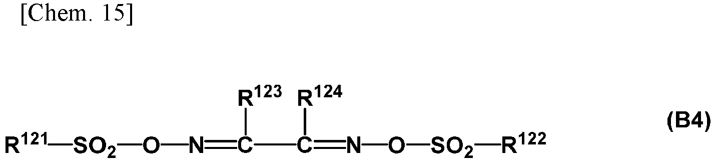

In formula (B4), R¹²¹ to R¹²⁴ are each independently a saturated hydrocarbyl group or halogenated saturated hydrocarbyl group of 1 to 12 carbon atoms, an aryl group of 6 to 12 carbon atoms which may have a substituent or an aralkyl group of 7 to 12 carbon atoms. R¹²³ and R¹²⁴ may mutually bond to form a ring together with the carbon atoms to which these are bonded. When they form a ring, the group formed by R¹²³ and R¹²⁴ bonding together is an alkanediyl group of 1 to 12 carbon atoms.

The saturated hydrocarbyl group, the halogenated saturated hydrocarbyl group, the aryl group which may have a substituent and the aralkyl group are respectively exemplified by the same groups as mentioned above as examples of the saturated hydrocarbyl group, the halogenated saturated hydrocarbyl group, the aryl group which may have a substituent and the aralkyl group represented by R¹¹¹ and R¹¹². Examples of the alkanediyl group include methylene, ethylene, propanediyl, butanediyl and hexanediyl groups.

Specific examples of the onium salts include diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, bis(4-tert-butylphenyl)iodonium hexafluorophosphate, 4-(phenylthiol)phenyldiphenylsulfonium tris(pentafluoroethyl)trifluorophosphate, diphenyl(4-thiophenoxyphenyl)sulfonium hexafluoroantimonate, [4-(4-biphenylylthio)phenyl]-4-biphenylylphenylsulfonium tris(trifluoromethanesulfonyl)methide, triphenylsulfonium tetrakis(fluorophenyl)borate, tris[4-(4-acetylphenyl)thiophenyl]sulfonium tetrakis(fluorophenyl)borate, triphenylsulfonium tetrakis(pentafluorophenyl)borate and tris[4-(4-acetylphenyl)thiophenyl]sulfonium tetrakis(pentafluorophenyl)borate.

Specific examples of the diazomethane derivatives include bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-pentylsulfonyl)diazomethane, bis(isopentylsulfonyl)diazomethane, bis(sec-pentylsulfonyl)diazomethane, bis(tert-pentylsulfonyl)diazomethane, 1 -cyclohexylsulfonyl-1 -(tert-butylsulfonyl)diazomethane, 1-cyclohexylsulfonyl-1-(tert-pentylsulfonyl)diazomethane and 1 -tert-pentylsulfonyl-1 -(tert-butylsulfonyl)diazomethane.

Specific examples of the glyoxime derivatives include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime and bis-o-(camphorsulfonyl)-α-dimethylglyoxime.

Specific examples of the β-ketosulfone derivatives include 2-cyclohexylcarbonyl-2-(p-toluenesulfonyl)propane and 2-isopropylcarbonyl-2-(p-toluenesulfonyl)propane.

Specific examples of the disulfone derivatives include diphenyldisulfone and dicyclohexyldisulfone.

Specific examples of the nitrobenzyl sulfonate derivatives include 2,6-dinitrobenzyl p-toluenesulfonate and 2,4-dinitrobenzyl p-toluenesulfonate.

Specific examples of the sulfonate ester derivatives include 1,2,3-tris(methanesulfonyloxy)benzene, 1,2,3-tris(trifluoromethanesulfonyloxy)benzene and 1,2,3-tris(p-toluenesulfonyloxy)benzene.

Specific examples of the imidoyl sulfonate derivatives include phthalimidoyl triflate, phthalimidoyl tosylate, 5-norbornene-2,3-dicarboxyimidoyl triflate, 5-norbornene-2,3-dicarboxyimidoyl tosylate, 5-norbornene-2,3-dicarboxyimidoyl n-butylsulfonate and n-trifluoromethylsulfonyloxy naphthylimide.

A specific example of the oxime sulfonate derivative is α-(benzenesulfonium oxyimino)-4-methylphenyl acetonitrile.

Specific examples of the iminosulfonate derivatives include (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)acetonitrile.

2-Methyl-2-[(4-methylphenyl)sulfonyl]-1-[(4-methylthio)phenyl]-1-propane and the like may also be suitably used.

The content of component (B) per 100 parts by weight of component (A) is preferably from 0.05 to 20 parts by weight, and more preferably from 0.1 to 5 parts by weight. At a component (B) content within the above range, sufficient photocurability is readily obtained and worsening of the curability in a thick film due to light absorption by the photoacid generator itself can be effectively prevented. Also, to obtain the transparency and light resistance that are features of this invention, the content of photoacid generator serving as component (B) that has light absorptivity should be low and within a range that does not hinder the photocurability. The photoacid generator serving as component (B) may be of one type used alone or two or more may be used together.

### [(C) Cation-Polymerizable Crosslinking Agent]

The photosensitive resin composition of the invention may additionally include, as component (C), a cation-polymerizable crosslinking agent. The cation-polymerizable crosslinking agent can give rise to cation polymerization reactions with epoxy groups on component (A) and is an ingredient for facilitating pattern formation. It also further increases the strength of the resin film after photocuring.

The crosslinking agent is a compound having a molecular weight of preferably from 100 to 15,000, and more preferably from 200 to 1,000. At a molecular weight of 100 or more, sufficient photocurability can be obtained; a molecular weight of 15,000 or less is desirable because there is no danger that the crosslinking agent will worsen the heat resistance of the composition after photocuring. The compound may be a resin (polymer), in which case the molecular weight is the weight-average molecular weight (Mw).

Compounds having functional groups selected from epoxy, oxetane and vinyl ether groups are preferred as the cation-polymerizable crosslinking agent. One of these compounds may be used alone or two or more may be used in combination.

The content of component (C) per 100 parts by weight of component (A) is from 0 to 100 parts by weight. When component (C) is included, from 0.5 to 100 parts by weight is preferred, from 0.5 to 60 parts by weight is more preferred, and from 1 to 50 parts by weight is even more preferred. At a component (C) content of 0.5 part by weight or more, sufficient curability is obtained upon light exposure; at 100 parts by weight or less, the proportion of component (A) within the photosensitive resin composition does not decrease, enabling the advantageous effects of the invention to be fully manifested in the cured product. Component (C) may be of one type used alone or two or more may be used in combination.

### [(D) Solvent]

The photosensitive resin composition of the invention may include a solvent as component (D) in order to increase the coatability thereof. The solvent (D) is not particularly limited, so long as it can dissolve above components (A) to (C), subsequently described component (E) and other additives.

The solvent (D) is preferably an organic solvent. Specific examples include ketones such as cyclohexanone, cyclopentanone and methyl-2-n-pentylketone; alcohols such as 3-metoxybutanol, 3-methyl-3-methoxybutanol, 1-methoxy-2-propanol and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate and γ-butyrolactone. One of these may be used alone or two or more may be used in admixture.

In particular, ethyl lactate, cyclohexanone, cyclopentanone, propylene glycol monomethyl ether acetate, γ-butyrolactone and mixed solvents of these, all of which have an excellent ability to dissolve photoacid generators, are preferred as the solvent (D).

Component (D) is included in an amount per 100 parts by weight of component (A) which, in terms of the compatibility and viscosity of the photosensitive resin composition, is preferably from 50 to 2,000 parts by weight, more preferably from 50 to 1,000 parts by weight, and even more preferably from 50 to 100 parts by weight.

### [(E) Antioxidant]

The photosensitive resin composition of the invention may include an antioxidant as an additive. By including an antioxidant, the heat resistance can be increased. Exemplary antioxidants include hindered phenolic compounds and hindered amine compounds.

The hindered phenolic compounds are not particularly limited, although preferred examples include the following: 1,3,5-trimethyl-2,4,6-tris(3,5-di-tert-butyl-4-hydroxybenzyl)benzene (trade name: IRGANOX 1330), 2,6-di-tert-butyl-4-methylphenol (trade name: Sumilizer BHT), 2,5-di-tert-butylhydroquinone (trade name: Nocrac NS-7), 2,6-di-tert-butyl-4-ethylphenol (trade name: Nocrac M-17), 2,5-di-tert-pentylhydroquinone (trade name: Nocrac DAH), 2,2'-methylenebis(4-methyl-6-tert-butylphenol) (trade name: Nocrac NS-6), 3,5-di-tert-butyl-4-hydroxybenzylphosphonate diethyl ester (trade name: IRGANOX 1222), 4,4'-thiobis(3-methyl-6-tert-butylphenol) (trade name: Nocrac 300), 2,2'-methylenebis(4-ethyl-6-tert-butylphenol) (trade name: Nocrac NS-5), 4,4'-butylidenebis(3-methyl-6-tert-butylphenol) (trade name: ADK Stab AO-40), 2-tert-butyl-6-(3-tert-butyl-2-hydroxy-5-methylbenzyl)-4-methylphenyl acrylate (trade name: Sumilizer GM), 2-[1-(2-hydroxy-3,5-di-tert-pentylphenyl)ethyl]-4,6-di-tert-pentylphenyl acrylate (trade name: Sumilizer GS), 2,2'-methylenebis[4-methyl-6-(α-methylcyclohexyl)phenol], 4,4'-methylenebis(2,6-di-tert-butylphenol) (trade name: Seenox 226M), 4,6-bis(octylthiomethyl)-o-cresol (trade name: IRGANOX 1520L), 2,2'-ethylenebis(4,6-di-tert-butylphenol), octadecyl-3-(3,5-di-tert-butyl-4-hydroxyphenyl) propionate (trade name: IRGANOX 1076), 1,1,3-tris-(2-methyl-4-hydroxy-5-tert-butylphenyl)butane (trade name: ADK Stab AO-30), tetrakis[methylene-(3,5-di-tert-butyl-4-hydroxyhydrocinnamate)]methane (trade name: ADK Stab AO-60), triethylene glycol bis[3-(3-tert-butyl-5-methyl-4-hydroxyphenyl) propionate] (trade name: IRGANOX 245), 2,4-bis-(n-octylthio)-6-(4-hydroxy-3,5-di-tert-butylanilino)-1,3,5-triazine (trade name: IRGANOX 565), N,N'-hexamethylenebis(3,5-di-tert-butyl-4-hydroxyhydrocinnamamide) (trade name: IRGANOX 1098), 1,6-hexanediolbis[3-(3,5-di-tert-butyl-4-hydroxyphenyl)propionate] (trade name: IRGANOX 259), 2,2-thiodiethylenebis[3-(3,5-di-tert-butyl-4-hydroxyphenyl)propionate] (trade name: IRGANOX 1035), 3,9-bis[2-[3-(3-tert-butyl-4-hydroxy-5-methylphenyl)propionyloxy]-1,1-dimethylethyl]-2,4,8,10-tetraoxaspiro[5.5]undecane (trade name: Sumilizer GA-80), tris(3,5-di-tert-butyl-4-hydroxybenzyl)isocyanurate (trade name: IRGANOX 3114), calcium bis(ethyl 3,5-di-tert-butyl-4-hydroxybenzylphosphonate)/polyethylene wax mixture (50:50) (trade name: IRGANOX 1425WL), isooctyl-3-(3,5-di-tert-butyl-4-hydroxyphenyl)propionate (trade name: IRGANOX 1135), 4,4'-thiobis(6-tert-butyl-3-methylphenol) (trade name: Sumilizer WX-R) and 6-[3-(3-tert-butyl-4-hydroxy-5-methylphenyl)propoxy]-2,4,8,10-tetra-tert-butyldibenz[d,f][1,3,2]dioxaphosphepin (trade name: Sumilizer GP).

The hindered amine compounds are not particularly limited, although preferred examples include the following: p,p'-dioctyldiphenylamine (trade name: IRGANOX 5057), phenyl-α-naphthylamine (trade name: Nocrac PA), poly(2,2,4-trimethyl-1,2-dihydroquinoline) (trade names: Nocrac 224, 224-S), 6-ethoxy-2,2,4-trimethyl-1,2-dihydroquinoline (trade name: Nocrac AW), N,N'-diphenyl-p-phenylenediamine (trade name: Nocrac DP), N,N'-di-β-naphthyl-p-phenylenediamine (trade name: Nocrac White), N-phenyl-N'-isopropyl-p-phenylenediamine (trade name: Nocrac 810NA), N,N'-diallyl-p-phenylenediamine (trade name: Nonflex TP), 4,4'-(α,α-dimethylbenzyl)diphenylamine (trade name: Nocrac CD), p,p-toluenesulfonylaminodiphenylamine (trade name: Nocrac TD), N-phenyl-N'-(3-methacryloxy-2-hydroxypropyl)-p-[phenylenediamine (trade name: Nocrac G1), N-(1-methylheptyl)-N'-phenyl-p-phenylenediamine (trade name: Ozonon 35), N,N'-di-sec-butyl-p-phenylenediamine (trade name: Sumilizer BPA), N-phenyl-N'-1,3-dimethylbutyl-p-phenylenediamine (trade name: Antigene 6C), alkylated diphenylamine (trade name: Sumilizer 9A), dimethyl succinate/1-(2-hydroxyethyl)-4-hydroxy-2,2,6,6-tetramethylpiperidine polycondensate (trade name: Tinuvin 622 LD), poly[[6-(1,1,3,3-tetramethylbutyl)amino-1,3,5-triazine-2,4-diyl][2,2,6,6-tetramethyl-4-piperidyl]imino]hexamethylene[(2,2,6,6-tetramethyl-4-piperidyl)imino]] (trade name: CHIMASSORB 944), N,N'-bis(3-aminopropyl)ethylenediamine/2,4-bis[N-butyl-N-(1,2,2,6,6-pentamethyl-4-piperidyl)amino]-6-chloro-1,3,5-triazine condensate (trade name: CHIMASSORB 119 FL), bis(1-octyloxy-2,2,6,6-tetramethyl-4-piperidyl)sebacate (trade name: TINUVIN 123), bis(2,2,6,6-tetramethyl-4-piperidyl)sebacate (trade name: TINUVIN 770), bis(1,2,2,6,6-pentamethyl-4-piperidyl) 2-(3,5-di-tert-butyl-4-hydroxybenzyl)-2-n-butylmalonate (trade name: TINUVIN 144), bis(1,2,2,6,6-pentamethyl-4-piperidyl)sebacate (trade name: TINUVIN 765), tetrakis(1,2,2,6,6-pentamethyl-4-piperidyl) 1,2,3,4-butanetetracarboxylate (trade name: LA-57), tetrakis(2,2,6,6-tetramethyl-4-piperidyl) 1,2,3,4-butanetetracarboxylate (trade name: LA-52), a mixed ester of 1,2,3,4-butanetetracarboxylic acid with 1,2,2,6,6-pentamethyl-4-piperidinol and 1-tridecanol (trade name: LA-62), a mixed ester of 1,2,3,4-butanetetracarboxylic acid with 2,2,6,6-tetramethyl-4-piperidinol and 1-tridecanol (trade name: LA-67), a mixed ester of 1,2,3,4-butanetetracarboxylic acid with 1,2,2,6,6-pentamethyl-4-piperidinol and 3,9-bis(2-hydroxy-1,1-dimethylethyl)-2,4,8,10-tetraoxaspiro[5.5]undecane (trade name: LA-63P), a mixed ester of 1,2,3,4-butanetetracarboxylic acid with 2,2,6,6-tetramethyl-4-piperidinol and 3,9-bis(2-hydroxy-1,1-dimethylethyl)-2,4,8,10-tetraoxaspiro[5.5]undecane (trade name: LA-68LD), (2,2,6,6-tetramethylene-4-piperidyl)-2-propylenecarboxylate (trade name: ADK Stab LA-82) and (1,2,2,6,6-pentamethyl-4-piperidyl)-2-propylenecarboxylate (trade name: ADK Stab LA-87).

The content of component (E) is not particularly limited so long as it does not detract from the advantageous effects of the invention. When component (E) is included, the content within the photosensitive resin composition of the invention is preferably from 0.01 to 1 wt%. The antioxidant serving as component (E) may be of one type used alone or two or more may be used together.

### [Other Additives]

In addition to the above ingredients, the photosensitive resin composition of the invention may also include other additives. Examples of such additives include surfactants that are commonly used, for example, to increase coatability.

The surfactant is preferably one that is nonionic, such as a fluorosurfactant, examples of which include perfluoroalkyl polyoxyethylene ethanols, fluorinated alkyl esters, perfluoroalkylamine oxides and fluorine-containing organosiloxane compounds. Commercially available products may be used as these. Specific examples include Fluorad^{®} FC-430 (from 3M Company), Surflon^{®} S-141 and S-145 (AGC Seimi Chemical Co., Ltd.), Unidyne^{®} DS-401, DS-4031 and DS-451 (Daikin Industries, Ltd.), Megaface^{®} F-8151 (DIC Corporation) and X-70-093 (Shin-Etsu Chemical Co., Ltd.). Of these, Fluorad FC-430 and X-70-093 are preferred. The content of this surfactant is not particularly limited so long as it does not detract from the advantageous effects of the invention. When a surfactant is included, the content is preferably from 0.01 to 1 wt% of the photosensitive resin composition of the invention.

A silane coupling agent may also be used as an additive. By including a silane coupling agent, adhesion of the photosensitive resin composition to the adherend can be further increased. The silane coupling agent is exemplified by epoxy silane coupling agents and aromatic group-containing aminosilane coupling agents. One of these may be used alone or two or more may be used in combination. The content of the silane coupling agent is not particularly limited so long as it does not detract from the advantageous effects of the invention. When a silane coupling agent is included, the content is preferably from 0.01 to 5 wt% of the photosensitive resin composition of the invention.

The method of preparing the photosensitive resin composition of the invention is not particularly limited. For example, the inventive photosensitive resin composition may be prepared by stirring and mixing together the above-described ingredients and, if necessary, subsequently filtering off the solids with a filter or the like.

### [Patterning Process]

The patterning process of the invention includes the steps of:
(i) forming a photosensitive resin film on a substrate using the above-described photosensitive resin composition,
(ii) exposing the photosensitive resin film to light, and
(iii) developing the exposed photosensitive resin film with a developer.
A fine pattern can be obtained by this process.

Step (i) forms a photosensitive resin film on a substrate using the above-described photosensitive resin composition. Exemplary substrates include silicon wafers, glass wafers, quartz wafers, plastic circuit substrates and ceramic circuit substrates.

The photosensitive resin film can be formed by a known method. For example, film formation can be carried out by using a method such as dipping, spin coating or roll coating to apply the above-described photosensitive resin composition onto a substrate. The amount of composition applied may be suitably selected according to the intended purpose, although an amount that results in a film thickness of from 0.1 to 100 µm is preferred.

To carry out the photocuring reaction efficiently, the solvent, etc. may be optionally evaporated by carrying out a pre-bake. The pre-bake may be carried out at, for example, between 40°C and 160°C for a period of from about 1 minute to about 1 hour.

Next, step (ii) exposes the photosensitive resin film to light. Exposure at this time is preferably carried out with light having a wavelength of from 240 to 500 nm. Examples of light having a wavelength of from 240 to 500 nm include light of various wavelengths generated by a radiation generator, such as g-line and i-line ultraviolet light, and far-infrared light (248 nm). The exposure dose is preferably from 10 to 5,000 mJ/cm².

Exposure may be carried out through a photomask. The photomask may be one in which a desired pattern has been cut out. The photomask material is preferably one which screens out light having the above wavelength of 240 to 500 nm. For example, chromium may be suitably used, although the photomask material is not limited to this.

In addition, a post-exposure bake (PEB) may be carried out to increase the sensitivity of development. PEB is carried out, for example, at between 40°C and 160°C for a period of from 5 to 30 minutes.

Following exposure or PEB, step (iii) develops the exposed photosensitive resin film with a developer. Preferred examples of the developer include organic solvent-based developers that are used as solvents, such as isopropyl alcohol, propylene glycol monomethyl ether and propylene glycol monomethyl ether acetate. Development using such an organic solvent-based developer gives a negative pattern in which unexposed areas have been dissolved and removed. Development may be carried out by a conventional method such as, for example, immersing the substrate on which a pattern has been formed in the developer. Washing, rinsing and drying are subsequently carried out as needed, giving a resin film having the desired pattern.

The patterning process is as described above, although when there is no need for patterning, such as in cases where one wishes to merely form a uniform film, film formation may be carried out by, in step (ii) of the above patterning process, exposure to light of a suitable wavelength without an intervening photomask.

In addition, where necessary, (iv) the film in which a pattern has been formed may be further treated to increase the crosslink density and remove remaining volatile ingredients by heating in an oven or on a hot plate at between 80°C and 300°C for a period of from about 10 minutes to about 10 hours (post-cure).

### [Optical Semiconductor Device]

An optical semiconductor device can be fabricated by carrying out fine patterning via the foregoing process on the above-described photosensitive resin composition. The film obtained from this photosensitive resin composition possesses excellent transparency, light resistance and heat resistance, and an optical semiconductor device having this film can be suitably used in the following types of optical devices: light-emitting devices such as light-emitting diodes, light receiving devices such as photodiodes, optical sensors and CMOS image sensors, and light-transmitting devices such as optical waveguides. The film has a transmittance to 400 nm wavelength light of preferably 92% or more, more preferably 96% or more, and most preferably 98% or more.

### EXAMPLES

Examples according to the invention and Comparative Examples are given below to more concretely illustrate the invention, although the invention is not limited by these Examples. In the Examples below, the weight-average molecular weight (Mw) was measured by gel permeation chromatography (GPC) against monodispersed polystyrene as the standard using a TSKGEL Super HZM-H column (Tosoh Corporation) and under the following conditions: a flow rate of 0.6 mL/min, using tetrahydrofuran (THF) as the eluting solvent, and a column temperature of 40°C.

### [1] Polymer Synthesis and Evaluation

The compounds that were used in polymer synthesis are shown below.

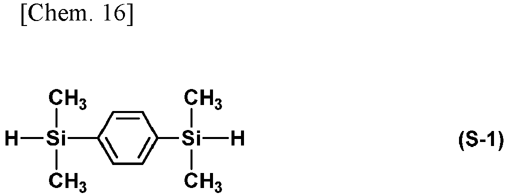

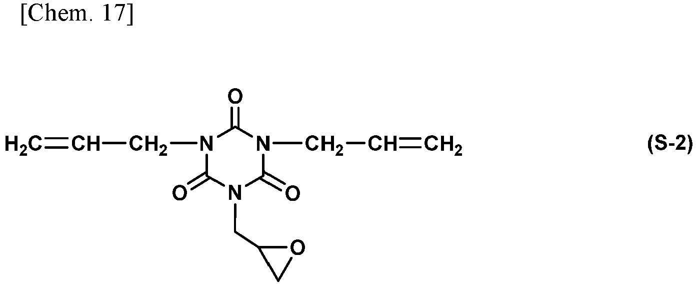

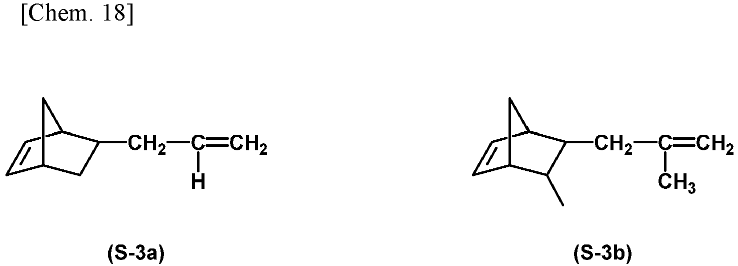

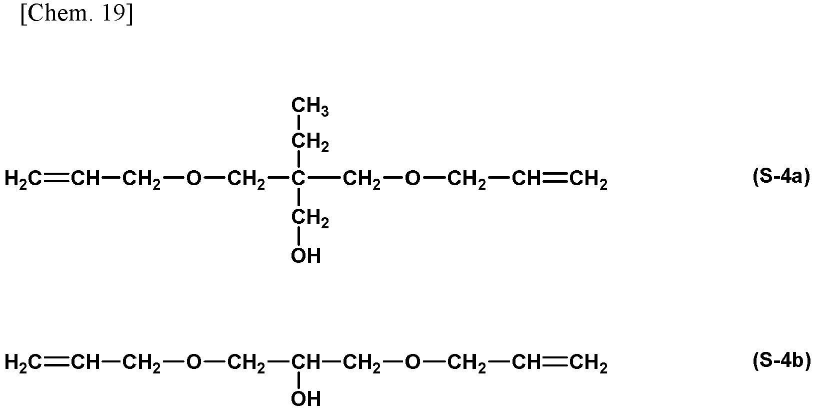

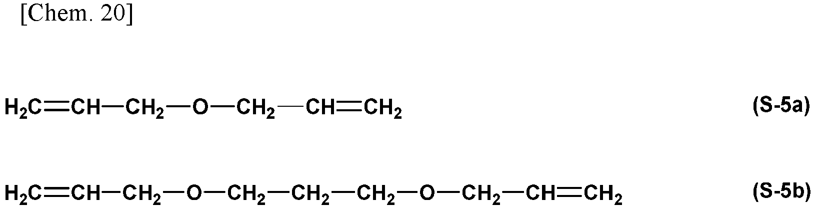

### [Example 1-1] Synthesis of Polymer 1

A ten-liter flask equipped with a stirrer, thermometer, nitrogen purging system and reflux condenser was charged with 53.0 g (0.20 mol) of the compound of formula (S-2), 48.1 g (0.40 mol) of the compound of formula (S-3) and 85.7 g (0.40 mol) of the compound of formula (S-4a), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 1. The Mw of Polymer 1 was 16,000. Polymer 1 was confirmed by analysis with a ¹H-NMR spectrometer (Bruker) to be a polymer that contains recurring units of formula (A1), recurring units of formula (A2) and recurring units of formula (A3).

### [Example 1-2] Synthesis of Polymer 2

A ten-liter flask equipped with a stirrer, thermometer, nitrogen purging system and reflux condenser was charged with 159 g (0.60 mol) of the compound of formula (S-2), 24.0 g (0.20 mol) of the compound of formula (S-3a) and 42.9 g (0.20 mol) of the compound of formula (S-4a), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 2. The Mw of Polymer 2 was 15,000. Polymer 2 was confirmed by analysis with a ¹H-NMR spectrometer (Bruker) to be a polymer that contains recurring units of formula (A1), recurring units of formula (A2) and recurring units of formula (A3).

### [Example 1-3] Synthesis of Polymer 3

A ten-liter flask equipped with a stirrer, thermometer, nitrogen purging system and reflux condenser was charged with 92.8 g (0.35 mol) of the compound of formula (S-2), 56.8 g (0.35 mol) of the compound of formula (S-3b) and 64.3 g (0.30 mol) of the compound of formula (S-4a), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 3. The Mw of Polymer 3 was 12,000. Polymer 3 was confirmed by analysis with a ¹H-NMR spectrometer (Bruker) to be a polymer that contains recurring units of formula (A1), recurring units of formula (A2) and recurring units of formula (A3).

### [Example 1-4] Synthesis of Polymer 4

A ten-liter flask equipped with a stirrer, thermometer, nitrogen purging system and reflux condenser was charged with 106 g (0.40 mol) of the compound of formula (S-2), 32.5 g (0.20 mol) of the compound of formula (S-3b) and 85.7 g (0.40 mol) of the compound of formula (S-4a), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 4. The Mw of Polymer 4 was 13,000. Polymer 4 was confirmed by analysis with a ¹H-NMR spectrometer (Bruker) to be a polymer that contains recurring units of formula (A1), recurring units of formula (A2) and recurring units of formula (A3).

### [Example 1-5] Synthesis of Polymer 5

A ten-liter flask equipped with a stirrer, thermometer, nitrogen purging system and reflux condenser was charged with 53.0 g (0.20 mol) of the compound of formula (S-2), 24.0 g (0.20 mol) of the compound of formula (S-3a) and 103 g (0.60 mol) of the compound of formula (S-4b), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 5. The Mw of Polymer 5 was 9,000. Polymer 5 was confirmed by analysis with a ¹H-NMR spectrometer (Bruker) to be a polymer that contains recurring units of formula (A1), recurring units of formula (A2) and recurring units of formula (A3).

### [Example 1-6] Synthesis of Polymer 6

A ten-liter flask equipped with a stirrer, thermometer, nitrogen purging system and reflux condenser was charged with 79.5 g (0.30 mol) of the compound of formula (S-2), 35.2 g (0.20 mol) of the compound of formula (S-3b) and 86.1 g (0.50 mol) of the compound of formula (S-4b), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 6. The Mw of Polymer 6 was 8,000. Polymer 6 was confirmed by analysis with a ¹H-NMR spectrometer (Bruker) to be a polymer that contains recurring units of formula (A1), recurring units of formula (A2) and recurring units of formula (A3).

### [Example 1-7] Synthesis of Polymer 7

A ten-liter flask equipped with a stirrer, thermometer, nitrogen purging system and reflux condenser was charged with 106 g (0.40 mol) of the compound of formula (S-2) and 129 g (0.60 mol) of the compound of formula (S-4a), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Polymer 7. The Mw of Polymer 7 was 11,000. Polymer 7 was confirmed by analysis with a ¹H-NMR spectrometer (Bruker) to be a polymer that contains recurring units of formula (A1), recurring units of formula (A2) and recurring units of formula (A3).

### [Comparative Example 1-1] Synthesis of Comparative Polymer 1

A ten-liter flask equipped with a stirrer, thermometer, nitrogen purging system and reflux condenser was charged with 53.0 g (0.20 mol) of the compound of formula (S-2), 48.1 g (0.40 mol) of the compound of formula (S-3a) and 56.5 g (0.40 mol) of the compound of formula (S-5a), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Comparative Polymer 1. The Mw of Comparative Polymer 1 was 10,000.

### [Comparative Example 1-2] Synthesis of Comparative Polymer 2

A ten-liter flask equipped with a stirrer, thermometer, nitrogen purging system and reflux condenser was charged with 92.8 g (0.35 mol) of the compound of formula (S-2), 56.8 g (0.35 mol) of the compound of formula (S-3b) and 59.8 g (0.30 mol) of the compound of formula (S-5b), following which 700 g of toluene was added and the flask contents were heated to 70°C. Next, 1.0 g of a toluene solution of chloroplatinic acid (platinum concentration, 0.5 wt%) was added and 192 g (0.99 mol) of the compound of formula (S-1) was added dropwise over one hour (total hydrosilyl groups/total alkenyl groups = 0.99/1 (molar ratio)). Following the completion of dropwise addition, the flask contents were heated to 100°C and aged for 8 hours, after which toluene was driven off under reduced pressure from the reaction solution, giving Comparative Polymer 2. The Mw of Comparative Polymer 2 was 12,000.

### [Light Transmission Test 1]

Polymers 1 to 7 and Comparative Polymers 1 and 2 were each dissolved in cyclopentanone to a concentration of 50 wt%, thereby preparing polymer solutions. Each polymer solution was coated onto a glass substrate, then heated at 60°C for 30 minutes and additionally heated in a nitrogen atmosphere at 190°C for 2 hours, producing in each case a film (thickness, 10 nm). The transmittance to 400 nm wavelength light of each of the resulting films was measured. The results are shown in Table 1. The film thickness was the thickness of a film formed beforehand on a silicon wafer under the same conditions, as measured with a light interference-type film thickness gauge from SCREEN.

**[Table 1]**

| | Example | | | | | | | Comparative Example | |
|---|---|---|---|---|---|---|---|---|---|
| | 1-1 | 1-2 | 1-3 | 1-4 | 1-5 | 1-6 | 1-7 | 1-1 | 1-2 |
| Light transmittance (%, 400 nm) | 98 | 97 | 99 | 97 | 96 | 97 | 97 | 97 | 98 |

### [Light Transmission Test 2]

A 400 nm, 1 W laser was continuously applied, within a 50°C oven, to samples composed of a film on glass wafer obtained by the above-described method, and the percent change in light transmittance after 100 hours and after 1,000 hours relative to 100% initially (before laser irradiation) was determined. The results are shown in Table 2.

**[Table 2]**

| | Laser irradiation time | Example | | | | | | | Comparative Example | |
|---|---|---|---|---|---|---|---|---|---|---|
| | | 1-1 | 1-2 | 1-3 | 1-4 | 1-5 | 1-6 | 1-7 | 1-1 | 1-2 |
| Change in light transmittance (%, 400 nm) | 100 hours | 97 | 97 | 98 | 97 | 96 | 96 | 97 | 97 | 97 |
| | 1,000 hours | 97 | 96 | 97 | 96 | 96 | 96 | 96 | 96 | 97 |

### [Curing Temperature Measurement Test 1]

Three parts by weight of CPI-210S (San-Apro Ltd.) as the photoacid generator was added to 100 parts by weight of the respective Polymers 1 to 7 and Comparative Polymers 1 and 2, following which cyclopentanone was added so as to bring the solids concentration to 50 wt%, and dissolution was carried out to uniformity. Two grams each of the respective solutions were placed in aluminum Petri dishes and dried by heating at a temperature of 100°C for 15 minutes. The remaining solid was exposed to 3,000 mJ of 365 nm light, following which differential scanning calorimetry was carried out and the curing temperature was evaluated from the exothermic peak. The results are shown in Table 3. Differential scanning calorimetry was carried out using the Q2000 from TA Instruments; the curing temperature was measured by raising the temperature from 0°C to 200°C at a rate of 10°C per minute.

**[Table 3]**

| | Example | | | | | | | Comparative Example | |
|---|---|---|---|---|---|---|---|---|---|
| | 1-1 | 1-2 | 1-3 | 1-4 | 1-5 | 1-6 | 1-7 | 1-1 | 1-2 |
| Peak temperature (°C) | 98 | 97 | 99 | 97 | 96 | 97 | 97 | 97 | 98 |

### [2] Preparation and Evaluation of Photosensitive Resin Compositions

### [Examples 2-1 to 2-11, Comparative Examples 2-1 to 2-8]

Photosensitive resin compositions were prepared by mixing together, stirring and dissolving Polymers 1 to 7 and Comparative Polymers 1 and 2 as component (A), Photoacid Generators B-1 and B-2 as component (B), Crosslinking Agents C-1, C-2 and C-3 as component (C) and cyclopentanone (CP) as the solvent serving as component (D) so as to arrive at the formulations shown in Tables 4 and 5 below, then carrying out microfiltration with a Teflon^{®} 0.2 µm filter.

**[Table 4]**

| Ingredients | | | Example | | | | | | | | | | |
|---|---|---|---|---|---|---|---|---|---|---|---|---|---|
| | | | 2-1 | 2-2 | 2-3 | 2-4 | 2-5 | 2-6 | 2-7 | 2-8 | 2-9 | 2-10 | 2-11 |
| (A) | Polymer | 1 | 100 | | | | | | | 100 | | | |
| | | 2 | | 100 | | | | | | | 100 | | |
| | | 3 | | | 100 | | | | | | | 50 | |
| | | 4 | | | | 100 | | | | | | 50 | |
| | | 5 | | | | | 100 | | | | | | 50 |
| | | 6 | | | | | | 100 | | | | | 50 |
| | | 7 | | | | | | | 100 | | | | |
| (B) | Photoacid generator | B-1 | 1 | | 1 | 1 | | | 1 | | 1 | | |
| | | B-2 | | 1 | | | 1 | 1 | | 5 | 1 | 2 | 2 |
| (C) | Crosslinking agent | C-1 | | | 10 | | | | 10 | | | 20 | |
| | | C-2 | | | | 10 | 50 | | | | | | 10 |
| | | C-3 | | | | | | 1 | | 1 | 20 | | 10 |
| (D) | Solvent | CP | 55 | 55 | 55 | 55 | 55 | 55 | 55 | 55 | 55 | 55 | 55 |

**[Table 5]**

| Ingredients | | | Comparative Example | | | | | | | |
|---|---|---|---|---|---|---|---|---|---|---|
| | | | 2-1 | 2-2 | 2-3 | 2-4 | 2-5 | 2-6 | 2-7 | 2-8 |
| (A) | Comparative polymer | 1 | 100 | | 100 | | 100 | | 100 | |
| | | 2 | | 100 | | 100 | | 100 | | 100 |
| (B) | Photoacid generator | B-1 | 1 | 1 | | | 1 | 1 | | |
| | | B-2 | | | 1 | 1 | | | 1 | 1 |
| (C) | Crosslinking agent | C-1 | 10 | 10 | 10 | 10 | | | | |
| | | C-2 | | | | | 10 | 10 | 10 | 10 |
| (D) | Solvent | CP | 55 | 55 | 55 | 55 | 55 | 55 | 55 | 55 |

In Tables 4 and 5, Photoacid Generators B-1 and B-2 and Crosslinking Agents C-1, C-2 and C-3 were as follows.

### • Photoacid Generators B-1 and B-2:

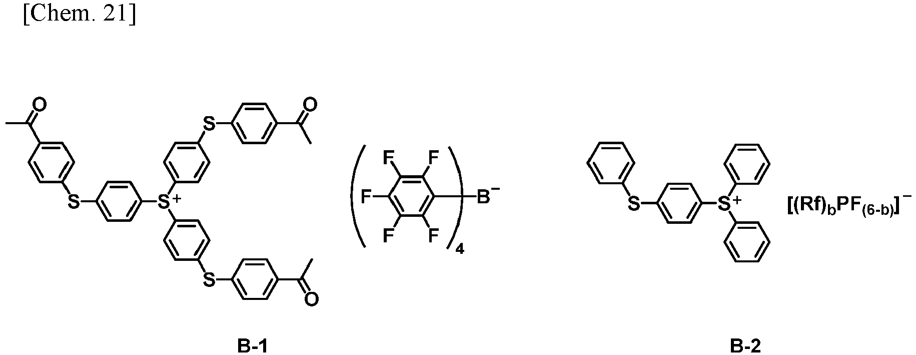

(wherein Rf is a perfluoroalkyl group, and b is from 0 to 6)

### • Crosslinking Agents C-1, C-2, C-3:

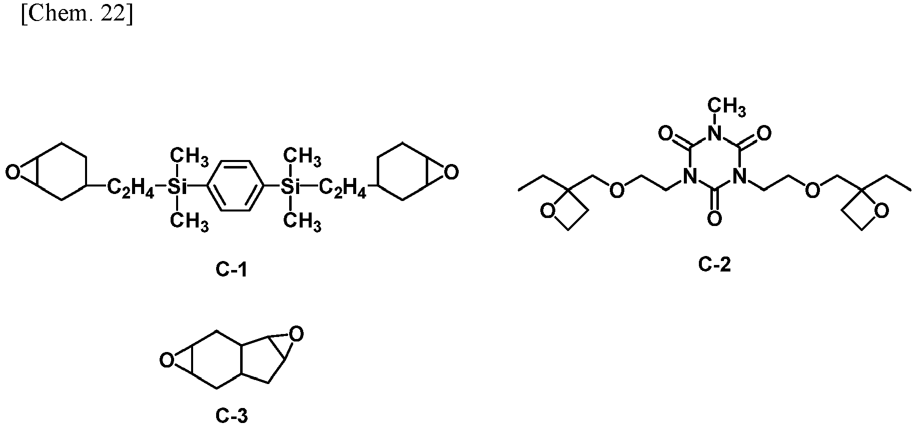

### [Patterning Evaluation]

Each of the photosensitive resin compositions was coated with a spin coater to a film thickness of 10 µm onto an 8-inch silicon wafer that had been primed with hexamethyldisilazane. To remove solvent from the composition, the wafer was placed on a hot plate and dried by 3 minutes of heating at 110°C. Using a contact aligner, the resulting photocurable resin film was exposed to 365 nm wavelength light through a mask in order to form a line-and-space pattern and a contact hole pattern. Following exposure, a 3-minute post-exposure bake (PEB) was carried out at 120°C on a hot plate, after which the wafer was cooled and then subjected to 300 seconds of spray development with propylene glycol monomethyl ether acetate (PGMEA), forming a pattern.

The patterned photosensitive resin film on a wafer thus obtained was post-cured under nitrogen purging at 190°C for 2 hours in an oven. Cross-sectional profiles of the 50 µm, 30 µm, 20 µm, 10 µm and 5 µm contact hole patterns that formed were examined with a scanning electron microscope (SEM) and the smallest hole pattern in which the holes reach the bottom of the film was treated as the limiting resolution. In addition, the perpendicularity of the 50 µm contact hole pattern was evaluated from the resulting cross-sectional image. A perpendicular pattern was rated as "Ⓞ"; a profile having a slightly reverse tapered shape was rated as "○"; a profile having a distinctly reverse tapered shape was rated as "△"; and a hole opening failure was rated as "×". The results are presented in Tables 6 and 7.

**[Table 6]**

| | Example | | | | | | | | | | |
|---|---|---|---|---|---|---|---|---|---|---|---|
| | 2-1 | 2-2 | 2-3 | 2-4 | 2-5 | 2-6 | 2-7 | 2-8 | 2-9 | 2-10 | 2-11 |
| Resin film thickness (µm) | 10 | 10 | 10 | 10 | 10 | 10 | 10 | 10 | 10 | 10 | 10 |
| Contact hole pattern shape | ⊚ | ○ | ⊚ | ⊚ | ○ | ⊚ | ○ | ⊚ | ○ | ○ | ⊚ |
| Limiting resolution (µm) | 10 | 10 | 5 | 5 | 5 | 5 | 5 | 5 | 5 | 5 | 5 |

**[Table 7]**

| | Comparative Example | | | | | | | |
|---|---|---|---|---|---|---|---|---|
| | 2-1 | 2-2 | 2-3 | 2-4 | 2-5 | 2-6 | 2-7 | 2-8 |
| Resin film thickness (µm) | 10 | 10 | 10 | 10 | 10 | 10 | 10 | 10 |
| Contact hole pattern shape | Δ | Δ | × | Δ | Δ | × | Δ | Δ |
| Limiting resolution (µm) | 50 | 50 | - | 50 | 50 | - | 50 | 50 |

### [Light Transmission Test 1]

Each of the photosensitive resin compositions was coated with a spin coater to a film thickness of 20 µm onto an 8-inch glass wafer. To remove solvent from the composition, the glass wafer was placed on a hot plate and dried by 3 minutes of heating at 110°C. Using the MA8 mask aligner from Suss MicroTec SE, the entire surface of the composition coated onto the glass wafer was irradiated with light from a high-pressure mercury vapor lamp (wavelength, 360 nm) as the light source without an intervening mask. This was followed by post-exposure bake, and then immersion in PGMEA. The film remaining after these operations was additionally heated for two hours in a 190°C oven, giving a finished film. The transmittance of this film to 400 nm wavelength light was measured using the U-3900H spectrophotometer from Hitachi High-Tech Corporation. The results are shown in Tables 8 and 9.

**[Table 8]**

| | Example | | | | | | | | | | |
|---|---|---|---|---|---|---|---|---|---|---|---|
| | 2-1 | 2-2 | 2-3 | 2-4 | 2-5 | 2-6 | 2-7 | 2-8 | 2-9 | 2-10 | 2-11 |
| Light transmittance (%, 400 nm) | 98 | 97 | 99 | 97 | 96 | 97 | 97 | 97 | 96 | 98 | 96 |

**[Table 9]**

| | Comparative Example | | | | | | | |
|---|---|---|---|---|---|---|---|---|
| | 2-1 | 2-2 | 2-3 | 2-4 | 2-5 | 2-6 | 2-7 | 2-8 |
| Light transmittance (%, 400 nm) | 96 | 97 | 96 | 98 | 96 | 97 | 96 | 96 |

### [Light Transmission Test 2]

A 400 nm, 1 W laser was continuously applied, within a 50°C oven, to samples composed of a film on glass wafer obtained by the above-described method, and the percent change in light transmittance after 100 hours and after 1,000 hours relative to 100% initially (before laser irradiation) was determined. The results are shown in Tables 10 and 11.

**[Table 10]**

| | Laser irradiation time | Example | | | | | | | | | | |
|---|---|---|---|---|---|---|---|---|---|---|---|---|
| | | 2-1 | 2-2 | 2-3 | 2-4 | 2-5 | 2-6 | 2-7 | 2-8 | 2-9 | 2-10 | 2-11 |
| Change in light transmittance (%, 400 nm) | 100 hours | 99 | 99 | 98 | 99 | 96 | 98 | 97 | 97 | 99 | 98 | 97 |
| | 1,000 hours | 98 | 99 | 97 | 97 | 96 | 98 | 97 | 96 | 99 | 97 | 96 |

**[Table 11]**

| | Laser irradiation time | Comparative Example | | | | | | | |
|---|---|---|---|---|---|---|---|---|---|
| | | 2-1 | 2-2 | 2-3 | 2-4 | 2-5 | 2-6 | 2-7 | 2-8 |
| Change in light transmittance (%, 400 nm) | 100 hours | 98 | 97 | 98 | 99 | 99 | 98 | 97 | 99 |
| | 1,000 hours | 98 | 96 | 97 | 98 | 99 | 96 | 96 | 98 |

### [Curing Temperature Measurement Test]

Two grams each of the respective photosensitive resin compositions were placed in aluminum Petri dishes and dried by heating at a temperature of 100°C for 15 minutes. The remaining solid was exposed to 3,000 mJ of 365 nm light, following which differential scanning calorimetry was carried out and the curing temperature was evaluated from the exothermic peak. Differential scanning calorimetry was carried out using the Q2000 from TA Instruments; the curing temperature was measured by raising the temperature from 0°C to 200°C at a rate of 10°C per minute. The results are shown in Tables 12 and 13.

**[Table 12]**

| | Example | | | | | | | | | | |
|---|---|---|---|---|---|---|---|---|---|---|---|
| | 2-1 | 2-2 | 2-3 | 2-4 | 2-5 | 2-6 | 2-7 | 2-8 | 2-9 | 2-10 | 2-11 |
| Peak temperature (°C) | 120 | 123 | 122 | 124 | 124 | 122 | 122 | 123 | 126 | 125 | 126 |

**[Table 13]**

| | Comparative Example | | | | | | | |
|---|---|---|---|---|---|---|---|---|
| | 2-1 | 2-2 | 2-3 | 2-4 | 2-5 | 2-6 | 2-7 | 2-8 |
| Peak temperature (°C) | 186 | 177 | 167 | 179 | 180 | 176 | 186 | 188 |

As is apparent from the above results, the inventive polymers containing a silphenylene skeleton, an isocyanuric acid skeleton and a hydroxyl group-substituted alkyl ether skeleton on the main chain and an epoxy group on a side chain had an excellent low-temperature curability. Also, films obtained from the inventive polymers had a high transparency and a high light resistance. Moreover, photosensitive resin compositions containing the inventive polymer were suitable for microfabrication, had excellent low-temperature curability, and yielded films of high transparency and high light resistance.

## Claims

1. A polymer comprising a silphenylene skeleton, an isocyanuric acid skeleton and a hydroxyl group-substituted alkyl ether skeleton on a main chain and an epoxy group on a side chain.

2. The polymer of claim 1, wherein the hydroxyl group-substituted alkyl ether skeleton has from 9 to 20 carbon atoms.

3. The polymer of claim 1 or 2, wherein the polymer includes recurring units of formula (A1) below, recurring units of formula (A2) below and recurring units of formula (A3) below 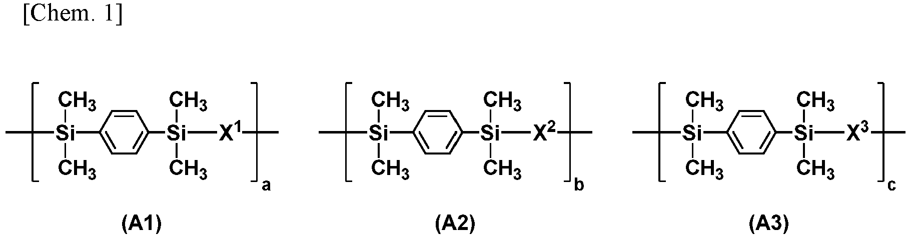 (wherein a, b and c are positive numbers that satisfy the conditions 0 < a < 1, 0 ≤ b < 1, 0 < c < 1 and a+b+c = 1; X¹ is a divalent group of formula (X1) below; X² is a divalent group of formula (X2) below; and X³ is a divalent group of formula (X3) below) 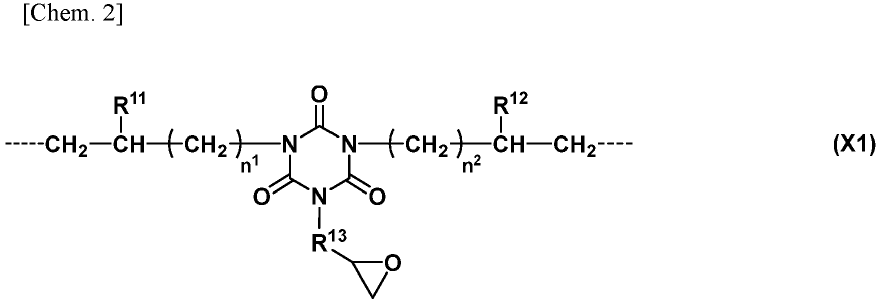 (wherein R¹¹ and R¹² are each independently a hydrogen atom or a methyl group; R¹³ is a hydrocarbylene group of 1 to 8 carbon atoms which may have an ester bond or ether bond interposed between carbon-carbon bonds thereon; n¹ and n² are each independently an integer from 0 to 7; and the dashed lines are bonds) 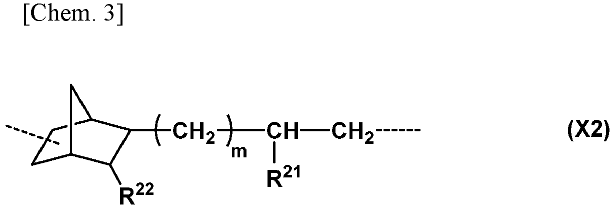 (wherein R²¹ and R²² are each independently a hydrogen atom or a saturated hydrocarbyl group of 1 to 20 carbon atoms which may include a heteroatom; m is an integer from 0 to 10; and the dashed lines are bonds) 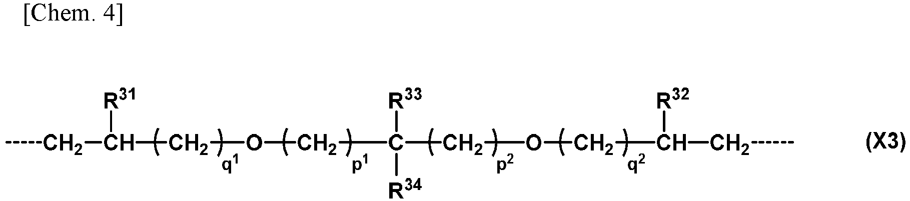 (wherein R³¹ and R³² are each independently a hydrogen atom or a methyl group; R³³ is a hydrogen atom or a saturated hydrocarbyl group of 1 to 20 carbon atoms which may include a heteroatom, with the proviso that R³³, when a saturated hydrocarbyl group, may include a primary or secondary alcoholic hydroxyl group as a substituent; R³⁴ is a hydroxyl group or a saturated hydrocarbyl group of 1 to 20 carbon atoms which may include a heteroatom, with the proviso that R³⁴, when a saturated hydrocarbyl group, may include a primary or secondary alcoholic hydroxyl group as a substituent; with the further provisos that when R³³ is a hydrogen atom and R³⁴ is a saturated hydrocarbyl group, R³⁴ includes at least one primary or secondary alcoholic hydroxyl group as a substituent; and when R³³ and R³⁴ are both saturated hydrocarbyl groups, one or both include at least one primary or secondary alcoholic hydroxyl group as a substituent; p¹ and p² are each independently an integer from 1 to 7; q¹ and q² are each independently an integer from 1 to 7; and the dashed lines are bonds).

4. The polymer of claim 3, wherein a, b and c are positive numbers which satisfy the conditions 0 < a < 1, 0 < b < 1, 0 < c < 1 and a+b+c = 1.

5. The polymer of claim 3 or 4, wherein R³⁴ is a linear alkyl group having a terminal hydroxyl group.

6. The polymer of any one of claims 3 to 5, wherein R³¹ and R³² are hydrogen atoms.

7. The polymer of any one of claims 3 to 6, wherein p¹ and p² are 1.

8. The polymer of any one of claims 3 to 7, wherein q¹ and q² are 1.

9. The polymer of any one of claims 1 to 8, wherein a 10 µm thick film made of the polymer has a transmittance to 400 nm wavelength light of 95% or more.

10. A photosensitive resin composition comprising the polymer of any one of claims 1 to 9 and (B) a photoacid generator.

11. The photosensitive resin composition of claim 10, further comprising (C) a cation-polymerizable crosslinking agent.

12. A patterning process comprising the steps of:
(i) forming a photosensitive resin film on a substrate using the photosensitive resin composition of claim 10 or 11,
(ii) exposing the photosensitive resin film to light, and
(iii) developing the exposed photosensitive resin film with a developer.

13. A method for fabricating an optical semiconductor device having a photosensitive resin film, comprising the patterning process of claim 12.
